# EUROPEAN PATENT SPECIFICATION

(11) **EP 0 381 280 B1**
(45) Date of publication and mention of the grant of the patent: **22.06.1994**
(21) Application number: 90200195.7
(22) Date of filing: 29.01.1990
(51) Int. Cl.: H01L 27/02, H01L 21/28

(54) **Method of manufacturing an integrated circuit with a protection element**
Verfahren zum Herstellen einer integrierten Schattung mit einem Schutzelement
Procédé de fabrication d'un circuit intégré avec un élément de protection

(30) Priority: 01.02.1989 NL 8900239
(43) Date of publication of application: 08.08.1990
(73) Proprietor: Philips Electronics N.V., 5621 BA Eindhoven (NL)
(72) Inventor: Van Roozendaal, Leonardus Johannes, NL-5656 AA Eindhoven (NL); Nagalingam Jebaretnam Sukendrakumar, Samuel, NL-5656 AA Eindhoven (NL)
(74) Representative: Rensen, Jan Geert

(56) References cited:
- EP-A- 0 057 024
- EP-A- 0 112 034
- LE VIDE, LES COUCHES MINCES, vol. 42, no. 236, March/April 1987, Paris, FR; A.G.M. JONKERS et al.: "Self aligned TiSi2 for submicron CMOS", pages 103-105

## Description

The invention relates to a method of manufacturing an integrated circuit in a semiconductor body substantially of monocrystalline silicon which comprises at least one protection element having at least one active zone forming a PN-junction with an adjoining silicon region and being contacted by an electrode layer comprising metal silicide which is connected to a point of the integrated circuit to be protected against electrostatic discharge.

A semiconductor device of the above kind is described *inter alia* in the article "Electrical Overstress in NMOS Silicided Devices" by D.J. Wilson *et al* in EOS/ESD Symposium Proceedings, September 29 to October 1, 1987, pp. 265-273.

Integrated circuits can often be subjected during their manufacture and treatment to electrostatic charges, which - and this applies especially to MOS and CMOS circuits having a high packing density and very thin gate oxide layers - can damage the circuit irreparably. This phenomenon is mostly designated in the literature by the abbreviation ESD (= ElectroStatic Discharge). For protection against these discharge phenomena, protection elements or protection circuits are usually included in the circuits, which have for their object to drain electrostatic charge, which is obtained, for example, by friction during the manipulation, by-passing the actual circuit. In this case, especially the speed at which this takes place and the threshold voltage at which the protection element becomes operative are of importance. As protection elements, use is made of lateral transistors or the parasitic lateral transistors of MOS transistors or the parasitic lateral transistors of MOS transistors or diodes.

In advanced integrated circuits according to the submicron technology having a high packing density, in which a low contact resistance especially at source and drain regions and gate electrodes is of major importance, these regions are contacted by means of self-aligned processes, in which the contact is formed by means of a metal silicide. These processes, in which a metal is provided throughout the surface, which then reacts with the exposed silicon by heating and forms a metal silicide, are known as "salicide" (short for self-aligned silicide) techniques. Preferably, as silicide, use is made of titanium silicide (TiSi₂) because this material has a very low electrical resistance, has a high temperature stability and has the capaciblity of reducing silicon oxide so that the titanium-silicon reaction cannot be hindered by an oxide film.

However, it has been found that, when for the protection elements, use is also made of these salicide processes, the protection properties are strongly adversely affected. See in this connection, for example, the aforementioned article by Wilson *et al*, p. 272, in which it is ascertained, that, for the aforementioned reasons, silicide processes should be avoided in protection systems. However, this results in a further complication of the already complicated process and therefore it would be very desirable when the protection elements could be manufactured simultaneously with the remaining part of the circuit whilst using the same technology.

The invention has *inter alia* for its object to provide a method of manufacturing an integrated circuit with at least one protction element, in which the protection element can be manufactured without additional processing steps in the same process as the remaining parts of the integrated circuit.

The invention is based *inter alia* on the recognition of the fact that the problems described above are at least to a considerable extent due to the fact that the interface between the metal silicide and the adjoining silicon substrate has an irregular shape in the usual method of manufacturing.

According to the invention a method as set out in claim 1 is provided.

In order to obtain an optimum result, the pattern of non-monocrystalline silicon preferably extends over a distance of at least 0.5 »m above the active zone and above the adjoining field oxide.

Although also other metals forming a suitable metal silicide, such as, for example, cobalt, could be used, a preferred embodiment of the invention is characterized in that a metal layer consisting of titanium is deposited on the semiconductor body, in that the heat treatment is carried out in a nitrogen containing atmosphere such that the any uncovered titanium of the metal layer present on the field oxide is converted into titanium nitride and silicon of the non-monocrystalline silicon layer is converted together with the subjacent part of the titanium layer into titanium silicide, in that the titanium nitride is subsequently removed selectively by means of an etching liquid and in that a second heat treatment is carried out at an higher temperature by which the titanium silicide is brought into the desired crystal form. At least two active zones are provided which constitute an emitter zone and a collector zone of a lateral bipolar transistor.

At the areas at which the non-monocrystalline silicon was provided on the metal, so preferably on titanium, metal and non-monocrystalline silicon are converted into metal silicide. Thus, metal silicide is also formed on the field oxide adjoining the active zone. Due to the fact that at the areas at which metal is diposed directly on the monocrystalline silicon the latter reacts considerably more slowly with the metal than the non-monocrystalline silicon diposed on the metal, the metal silicide boundary in the active zones of the protection elements lies at a much smaller depth than in processes in which no non-monocrystalline silicon is provided on the metal, and this boundary is much more regular. Moreover, the distance of the silicide from the pn junction increaes, which leads to a higher series resistance of the protection element. Both effects contribute to avoiding the occurrence of undesired current concentrations, as will be explained more fully hereinafter.

It should be noted that it is known *per se* to form electrically conducting titanium silicide compounds on oxide by covering the metal with amorphous silicon; see, for example, the article "Self-aligned TiSi₂ for submicron CMOS" by A.G.M. Jonkers *et al* in "Le vide/Les couches minces" Vol. 42, No. 236, March/April 1987, pp. 103-105. In this article, this technique is used solely for forming connections over the oxide. However, no mention is made therein of an application in the manufacture of protection elements, or of the advantage of the smaller penetration depth of the silicide into monocrystalline silicon, more particularly with respect to the properties of protection elements.

Also it is known per se from European Patent Application No. 112 034 to form an electrode layer of metal silicide partially on an oxide layer. However, instead of by silicidation, like in the method of the invention, the known electrode layer is however formed by depositing a conformal metal silicide layer on the whole surface and subsequently patterning said layer by a conventional photo-lithographical technology. Consequently this will not enable the formation of a relatively shallow, more regular metal silicide boundary in an active silicon zone whose surface is converted in metal silicide.

The invention will now be described more fully with reference to an embodiment and the drawing, in which:
Fig. 1 shows a circuit diagram of the input part of a semiconductor device comprising a protection element obtainable by a method according to the invention,
Fig. 2 shows a current-voltage characteristic of the protection element of the device shown in Fig. 1,
Fig. 3 shows diagrammatically a cross-section of the device shown in Fig. 1,
Fig. 4 shows diagrammatically a cross-section of a part of a protection element according to the standard technique,
Fig. 5 shows diagrammatically a cross-section of a part of the protection element obtainable by a method according to the invention, and
Figs. 6 to 9 show cross-sections of the element shown in Fig. 5 at successive stages of manufacture according to an embodiment of the method according to the invention.

The Figures are schematic and not drawn to scale. Corresponding parts are generally designated by the same reference numerals. In the cross-sections, semiconductor regions of the same conductivity type are cross-hatched in the same direction.

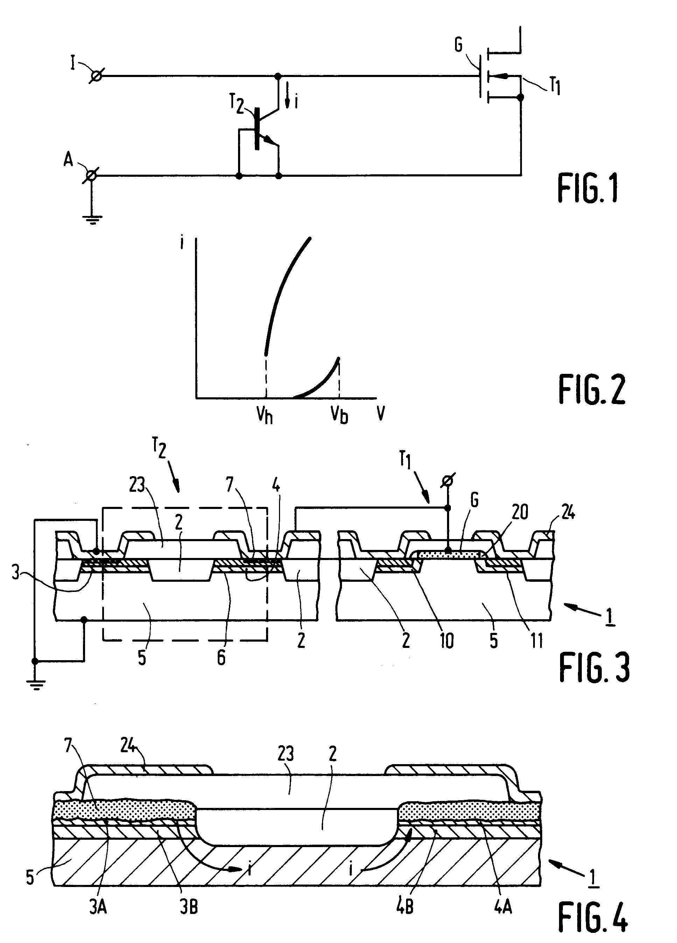

Fig. 1 shows a circuit diagram of a part (the input part) of a semiconductor device comprising a protection circuit according to the invention. The device comprises an integrated circuit, in which in Fig. 1 (right-hand side) only one insulated gate field effect transistor T1, further designated as MOS transistor, is shown. This transistor, in this embodiment an N-channel or NMOS transistor, is electrically connected to a number of further circuit elements, which, however, are not essential to the invention and are therefore not shown in the drawing.

The gate electrode G of the NMOS transistor T1 is connected to an input I of the circuit. At this input I, an electrostatic charge can be formed, which, when it would be discharged through the transistor T1, could irreparably damage the circuit.

In order to avoid this, a protection element is provided, which in this embodiment consists of a bipolar npn transistor T2, whose emitter and base are connected to a ground reference potential terminal A, which is connected, for example, to earth. The collector is connected to the said input I of the circuit. The current-voltage characteristic i-V of the transistor T2 is shown diagrammatically in Fig. 2. When such a high voltage V is applied to the input I that the avalanche breakdown voltage Vb is exceeded, the current i rapidly increases, whereas the voltage across T2 strongly decreases, which phenomenon is known under the designation "snap-back". The electrostatic charge at the input is now drained to earth via the transistor T2 without the risk of damaging the circuit.

Fig. 3 shows diagrammatically in cross section a practical embodiment of such a semiconductor device. The device comprises a semiconductor body 1 of monocrystalline silicon having a monolithic integrated circuit, of which also in Fig. 3 only the MOS transistor T1 is shown. The device comprises a field oxide pattern, in this embodiment a pattern of sunken oxide 2 (LOCOS), but this is not necessary and any other form of sunken or not sunken field oxide may be used. The protection element, in this embodiment a bipolar lateral npn transistor T2, comprises two active zones 3 and 4 of one conductivity type, in this embodiment the conductivity type, which constitute the emitter zone and the collector zone, respectively, of T2. The zones 3 and 4 both adjoin the field oxide 2 as well as the adjacent silicon region 5 of the second opposite conductivity type, in this embodiment therefore the p-conductivity type. This region 5 may be constituted by the substrate itself or, for example, by an epitaxial layer present on the substrate. Both zones 3 and 4 form a pn junction with the region 5, the pn junction 6 between the collector zone 4 and the region 5 being biased in the reverse direction in the operating condition at least temporarily and at any rate upon elimination of electrostatic charge at the input I. It is further indicated in the drawing that the active zones 3 and 4, like the source and drain zones 10 and 11 of the MOS transistor T1, consist of more highly doped first regions 3A, 4A and more weakly doped second regions 3B, 4B, which adjoin the "first" regions. This measure serves to prevent injection of "hot" charge carriers into the gate electrodes of the MOS transistors, but is not essential to the invention.

The active zone 4 is contacted (on the part 4A) with an electrode layer 7, which is connected to a point of the semiconductor device to be protected against static discharge, in this case the gate electrode G of T1. This electrode layer 7 consists of a metal silicide, mostly, and also in this embodiment, of titanium silicide.

Fig. 4 shows in a greater detail the part of Fig. 3 within the dotted line. The situation is shown therein, which arises when the metal silicide is provided in the manner usual in the salicide technology. It clearly appears from Fig. 4 that the transition between the titanium silicide and the silicon causes the series resistance in the current path through the region 4A to vary strongly and moreover to be comparatively small because of the comparatively large penetration depth of the silicide. As a result, current concentrations occur at the area of the lowest series resistance, which results in an unacceptable deterioration of the protection properties.

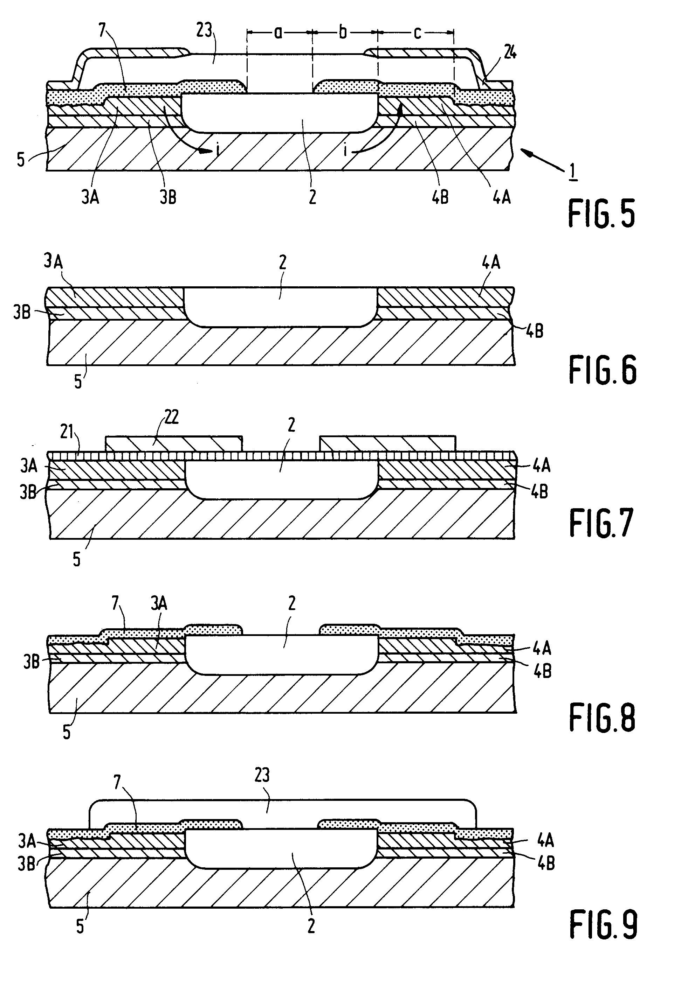

Fig. 5 shows the situation arising when the measure according to the invention is used. In this case, the metal silicide 7 extends in contrast with the situation shown in Fig. 4, also on the field oxide 2 adjoining the active zone 4. This is possible only when, as will be explained more fully hereinafter, the metal was covered with amorphous silicon during the silicide formation, as a result of which the metal has in the proximity of the field oxide a considerably smaller penetration depth into the monocrystalline silicon of the region 5. As a result, the interface between the metal and the adjoining underlying silicon is such more regular and is also farther remote from the interface between the subregions 4A and 4B so that the series resistance also increases. Both factors contribute to a considerable reduction of the aforementioned disadvantages or even elimination thereof.

The semiconductor device described above can be manufactured according to the invention in the following manner (see Figs. 6 to 9).

The starting material is a P-type silicon substrate 5. As has already been stated above, the substrate 5 may be constituted either by the silicon wafer as a whole or by an epitaxial P-type silicon layer formed on a carrier body. This substrate 5 is provided with a field oxide pattern in a usual manner. In this embodiment, a sunken oxide pattern 2 is provided in known manner whilst using nitride masking, etching and heating. See Fig. 6.

After the thin "gate oxide" required for the gate electrode structures with on it the polycrystalline silicon pattern for the gate electrodes has been provided, first the zones 3B, 4B and the remaining lightly doped source and drain zones (10B, 11B) of the MOS transistors are formed by implantation of phosphorus ions at a dose of, for example 4.10¹³ ions/cm² and an energy of, for example, 80 keV followed by a drive-in heat treatment. Subsequently, after oxide "spacers" 20 (cf. Fig. 3) have been provided by deposition of an oxide layer and then back-etching by reactive ion etching (RIE), the n⁺ zones 3A, 4A, 10A, 11A are formed by implantation of, for example, arsenic ions at 100 keV and a dose of, for example, 5.10¹⁵ ions/cm² and by a drive-in step. After the thin oxide formed during the preceding steps has been etched away, the situation of the region within the dotted line of Fig. 3 is that shown in Fig. 6.

By sputtering, a metal layer, in this embodiment a titanium layer 21 having a thickness of 40 nm, and an amorphous silicon layer 22 having a thickness of 100 nm are now successively deposited. By masking and etching, the amorphous silicon 22 is now etched into a pattern which extends both above the active zone 4 and above the field oxide 2 and the zone 3. Thus, the situation shown in Fig. 7 is obtained. It should further be noted, that the amorphous silicon, which is located in the drawing only above a part of the zones 3 and 4, may also extend above the whole surface of these zones.

Subsequently, a heat treatment is carried out in nitrogen at about 675°C for about 30 seconds. During this treatment, the titanium not covered with amorphous silicon is wholly converted into titanium nitride, while the titanium covered with amorphous silicon 22 is converted into titanium silicide 7, the amorphous silicon layer 22 being converted entirely, but the monocrystalline silicon of the regions 3A and 4A underlying the titanium 21 being converted only over a small depth into titanium silicide. This is due to the fact that the amorphous silicon reacts such more rapidly with titanium than the monocrystalline silicon.

The titanium nitride formed is now removed by wet etching in a mixture of H₂O₂, NH₃ and H₂O, whereupon a second heat treatment is carried out at a higher temperature (about 875°C) to convert the titanium silicide, which initially has the metastable C49 structure, into the stable C54 structure. The situation is now that shown in Fig. 8.

A pyrolytic (CVD) oxide layer 23 is then deposited, into which contact holes are etched in the usual manner. Thus, the situation of Fig. 9 is obtained. Finally, after the metallization 24 of, for example, aluminium has been provided, the situation of Fig. 5 is attained. In this embodiment, the distance a (see Fig. 5) is 0.9 »m, the distance b is 0.5 »m and the distance c is 1.0 »m. The "shallow" titanium silicide therefore extends 1 »m beyond the boundary of the field oxide 2 so that practically the whole transistor current flows through the shallow regularly formed silicide.

Since elsewhere in the integrated circuit through-connections over the field oxide mostly have to be formed by means of layer parts of amorphous silicon provided on the metal, the invention may be used without additional masking and alignment steps being necessary.

The invention is not limited to the embodiment described. For example, the configuration of the protection element may be different from that in the embodiment shown. Instead of a lateral transistor, for example also a protection diode may be used. The latter can be obtained when in Fig. 5 the zone (4A, B) has the same conductivity type as the region 5. Further, if desired, metals other than titanium may be used. In the embodiment described, the conductivity types may also be replaced (all simultaneously) by the opposite types.

## Claims

1. A method of manufacturing an integrated circuit in a semiconductor body (1) of monocrystalline silicon which comprises at least one protection element (T2) having at least one active zone (3,4) forming a PN-junction with an adjoining silicon region (5) and being contacted by an electrode layer comprising metal silicide (7) which is connected to a point (6) of the integrated circuit to be protected against electrostatic discharge, whereby
- said semiconductor body (1) is provided with a field oxide pattern (2);
- a dopant of a first conductivity type is introduced in a self-aligned manner by ion implantation into a region (3,4) of said semiconductor body (1) of a second, opposite conductivity type adjoining said field oxide pattern in order to form said active zone;
- a metal layer (21) and an amorphous silicon layer (22) are successively deposited on said semiconductor body (1);
- said amorphous silicon layer (22) is etched into a pattern which extends over parts of both said active zone and said field oxide (2);
- a heat treatment is performed by which said amorphous silicon and the underlying metal are converted entirely and any uncovered metal lying directly on said monocrystalline silicon semiconductor body is converted only partially into metal silicide (7);
- any metal not converted into silicide is removed;
- an insulating layer (23) is deposited on said semiconductor body (1), in which
- contact windows and a metallization (24) contracting said silicide layer (7)
are provided.

2. A method as claimed in claim 1 **characterized in that** the pattern out of the amorphous silicon layer (22) extends over a distance of at least 0.5 »m over the active zone (3,4) and over the adjoining part of the field oxide (2).

3. A method as claimed in any one of the preceding claims **characterized in that** said metal layer (21) is titanium.

4. A method as claimed in claim 3 **characterized in that** the heat treatment is carried out in a nitrogen containing atmosphere such that the any uncovered titanium of the metal layer (21) present on the field oxide (2) is converted into titanium nitride and the silicon of the amorphous silicon layer (22) converted together with the subjacent part of the titanium layer (21) into titanium silicide, in that the titanium nitride is subsequently removed selectively by means of an etching liquid and in that a second heat treatment is carried out at an higher temperature by which the titanium silicide is brought into the desired crystal form.

5. A method as claimed in any of the preceding claims **characterized in that** at least two active zones (3,4) are provided which constitute an emitter zone and a collector zone of a lateral bipolar transistor.

## Patentansprüche

1. Verfahren zum Herstellen einer integrierten Schaltung in einem Halbleiterkörper (1) aus einkristallinem Silizium, die mindestens ein Schutzelement (T2) mit mindestens einer aktiven Zone (3, 4) umfaßt, welche einen PN-Übergang zu einem angrenzenden Siliziumbereich (5) bildet und mit einer Elektrodenschicht, die Metallsilizid (7) umfaßt, kontaktiert wird, die mit einem Punkt (6) der vor elektrostatischer Entladung zu schützenden integrierten Schaltung verbunden wird, wobei
- der Halbleiterkörper (1) mit einer Feldoxidstruktur (2) versehen wird;
- ein Dotierungsstoff eines ersten leitfähigkeitstyps in einen Bereich (3, 4) des Halbleiterkörpers (1) eines zweiten, entgegengesetzten Leitfähigkeitstyps, der an die Feldoxidstruktur angrenzt, in selbstjustierender Weise mittels Ionenimplantation eingebracht wird, um die aktive Zone zu bilden;
- eine Metallschicht (21) und eine amorphe Siliziumschicht (22) nacheinander auf den Halbleiterkörper (1) aufgetragen werden;
- die amorphe Siliziumschicht (22) so geätzt wird, daß eine Struktur entsteht, die sich über Teile der aktiven Zone sowie das Feldoxid (2) erstreckt;
- eine Wärmebehandlung durchgeführt wird, wodurch das amorphe Silizium und das darunterliegende Metall komplett umgewandelt werden und alles unbeschichtete, sich direkt auf dem Halbleiterkörper aus einkristallinem Silizium befindliche Metall nur teilweise in Metallsilizid (7) umgewandelt wird;
- alles nicht in Silizid umgewandelte Metall entfernt wird;
- eine Isolierschicht (23) auf den Halbleiterkörper (1) aufgebracht wird, worin Kontaktfenster und eine Metallisierung (24) zum Kontaktieren der Silizidschicht (7) angebracht werden.

2. Verfahren nach Anspruch 1, dadurch gekennzeichnet, daß die Struktur aus der amorphen Siliziumschicht (22) sich mindestens 0,5 »m über die aktive Zone (3, 4) und den angrenzenden Teil des Feldoxids (2) erstreckt.

3. Verfahren nach einem der vorhergehenden Ansprüche, dadurch gekennzeichnet, daß die Metallschicht (21) aus Titan besteht.

4. Verfahren nach Anspruch 3, dadurch gekennzeichnet, daß die Wärmebehandlung in einer stickstoffhaltigen Atmosphäre durchgeführt wird, so daß alles unbeschichtete Titan der auf dem Feldoxid (2) befindlichen Metallschicht (21) in Titannitrid und das Silizium der amorphen Siliziumschicht (22) zusammen mit dem darunterliegenden Teil der Titanschicht (21) in Titansilizid umgewandelt wird, daR das Titannitrid danach gezielt mittels einer Ätzflüssigkeit entfernt wird und daR eine zweite Warmebehandlung bei einer höheren Temperatur durchgeführt wird, mit der das Titansilizid die gewünschte Kristallform erhält.

5. Verfahren nach einem der vorhergehenden Ansprüche, dadurch gekennzeichnet, daß mindestens zwei aktive Zonen (3, 4) erzeugt werden, die eine Emitterzone und eine Kollektorzone eines Lateral-Bipolar-Transistors bilden.

## Revendications

1. Procédé de fabrication d'un circuit intégré dans un corps semiconducteur (1) consistant essentiellement en silicium monocristallin et comportant au moins un élément de protection (T2) pourvu d'au moins une zone active (3, 4) qui, avec une région de silicium contiguë (5), forme une jonction pn et qui est mise en contact par une couche d'électrode comportant du siliciure de métal (7) et reliée à un point (6) du circuit intégré devant être protégé contre les décharges électrostatiques, procédé selon lequel
- on recouvre ledit corps semiconducteur (1) d'une configuration d'oxyde de champ (2);
- par implantation ionique, on introduit un dopant d'un premier type de conductivité par auto-alignement dans une région (3, 4) d'un second type de conductivité opposée dudit corps semiconducteur, contiguë' à ladite configuration d'oxyde de champ, pour créer ladite zone active;
- sur ledit corps semiconducteur (1), on dépose successivement une couche métallique (21) et une couche de silicium amorphe (22);
- par gravure, on met en configuration ladite couche de silicium amorphe (22), la configuration s'étendant sur des parties de ladite zone active ainsi que dudit oxyde de champ (2);
- on effectue un traitement thermique par lequel le silicium amorphe et le métal sous-jacent sont convertis entièrement et tout métal découvert, situé directement sur ledit corps semiconducteur de silicium monocristallin, n'est converti que partiellement en siliciure de métal (7);
- on élimine tout métal non converti en siliciure;
- sur ledit corps semiconducteur (1), on dépose une couche isolante (23) dans laquelle on forme des fenêtres de contact et une métallisation (24) mettant en contact ladite couche de siliciure (7).

2. Procédé selon la revendication 1, caractérisé en ce que la configuration formée à partir de la couche de silicium amorphe (22) s'étend sur la zone active (3, 4) et la partie contiguë de l'oxyde de champ (2) sur une distance d'au moins 0,5 »m.

3. Procédé selon l'une quelconque des revendications précédentes, caractérisé en ce que ladite couche métallique (21) est en titane.

4. Procédé selon la revendication 3, caractérisé en ce qu'on effectue le traitement thermique dans une atmosphère contenant de l'azote de façon que tout titane découvert de la couche métallique (21) et situé sur l'oxyde de champ (2) soit converti en nitrure de titane et que le silicium de la couche de silicium amorphe (22) soit converti, conjointement avec la partie sous-jacente de la couche de titane (21) en siliciure de titane, en ce que, ensuite, on élimine le nitrure de titane de façon sélective au moyen d'un décapant et en ce qu'on procède à un deuxième traitement thermique à une température plus élevée, permettant de donner au siliciure de titane la forme cristalline souhaitée.

5. Procédé selon l'une quelconque des revendications précédentes, caractérise en ce qu'on forme aux moins deux zones actives (3, 4) constituant une zone d'émetteur et une zone de collecteur d'un transistor bipolaire latéral.
